# EUROPÄISCHE PATENTANMELDUNG

(11) **EP 0 696 881 A1**
(43) Veröffentlichungstag der Anmeldung: **14.02.1996**
(21) Anmeldenummer: 95111827.2
(22) Anmeldetag: 28.07.1995
(51) Int. Cl.: H05K 5/00

(54) **Kunststoffgehäuse für ein elektrisches Modul**

(30) Priorität: 10.08.1994 DE 4428335
(71) Anmelder: DODUCO GMBH + Co Dr. Eugen Dürrwächter, D-75181 Pforzheim (DE)
(72) Erfinder: Gebhard, Reiner, D-75239 Eisingen (DE); Kaspar, Franz, Dr., D-75223 Niefern (DE); Kessler, Ralf, D-76137 Karlsruhe (DE); Kühnle, Andreas, D-75433 Maulbronn (DE); Ney, Joachim, D-75223 Niefern (DE); Normann, Norbert, Dr., D-75223 Niefern (DE); Schulze, Gunter, D-75228 Ispringen (DE)
(74) Vertreter: Twelmeier, Ulrich, Dipl. Phys.

(57) **Zusammenfassung**

Beschrieben ist ein Kunststoffgehäuse für ein elektrisches Modul, das einen Gehäusekörper (1) mit mindestens einer Durchtrittsöffnung (5) für Kontaktelemente (4a-4c) des im Gehäusekörper (1) aufnehmbaren elektrischen Moduls (3) aufweist, wobei der Gehäusekörper (1) und/oder das elektrische Modul (3) mindestens ein die Durchtrittsöffnung (5) abdichtendes Dichtelement (20a-20c;30,40) aus elastischem Material aufweist, und wobei das mindestens eine Dichtelement (20a-20c;30;40) aus elastischem Material auf den Gehäusekörper (1) und/oder auf dem elektrischen Modul (3) aufgespritzt oder aufgedruckt oder mit einem Dispenser aufgetragen ist.

## Beschreibung

Die Erfindung betrifft ein Kunststoffgehäuse für ein elektrisches Modul.

Es ist bekannt, daß bei derartigen Kunststoffgehäusen Kontaktstifte, welche das im Inneren des Kunststoffgehäuses aufgenommene elektrische Modul mit einem außerhalb dieses Kunststoffgehäuses befindlichen Steckelement verbinden, direkt mit dem Gehäuse als Spritzgußteil hergestellt werden. Hierbei werden die metallischen Kontaktelemente während des Spritzvorgangs des Kunststoffgehäuses mit eingebettet oder nachträglich, z.B. durch Einpressen, montiert.

Eine derartige Verfahrensweise besitzt den Nachteil, daß diese Art der Durchführung der Kontaktstifte durch einen Durchtrittsbereich des Kunststoffgehäuses hinsichtlich der Dichtheit des Gehäuses stark von der verwendeten Fügetechnik und der Konstruktion dieser Komponenten abhängt. Auf jeden Fall ist diese Vorgangsweise sehr kostenintensiv, insbesondere aufgrund bei der Mehrzahl der Anwendungsfälle erforderlichen zusätzlichen Maßnahmen zur Sicherstellung der Dichtheit, wie z.B. Vergießen der Kontaktstifte mit aushärtbarem Dichtmittel, Verkleben der Kontaktstifte oder das Einsetzen zusätzlicher Dichtungen.

Es ist daher Aufgabe der Erfindung, ein bekanntes Kunststoffgehäuse für ein elektrisches Modul derart weiterzubilden, daß eine preisgünstige Herstellung ermöglicht wird, wobei gleichzeitig eine hinreichende Dichtheit desselben gewährleistet ist.

Diese Aufgabe wird erfindungsgemäß durch die Merkmale des Anspruchs 1 gelöst.

Die erfindungsgemäße Lösung besitzt den Vorteil, daß durch die auf den Gehäusekörper und/oder das elektrische Modul angespritzten oder aufgedruckten oder mit einem Dispenser aufgetragenen Dichtelemente aus elastischem Material, insbesondere aus elastomerem Kunststoff, es besonders einfach möglich ist, auf sehr kostengünstigem Weg eine dichte Durchführung von Kontaktelementen durch ein Kunststoffgehäuse zu schaffen, da alle Dichtelemente des Gehäusekörpers oder des elektrischen Moduls in einem einzigen Arbeitsgang einfach hergestellt werden können. Das erfindungsgemäße Kunststoffgehäuse zeichnet sich außerdem durch eine zuverlässige Abdichtung der Durchtrittsöffnung durch die erfindungsgemäß ausgeführten Dichtelemente aus und gewährleistet eine unkritische Montage auch kompliziert strukturierter Module, wobei das Kunststoffgehäuse dennoch in vorteilhafter Art und Weise ein werkzeugfallendes Kunststoffteil bleibt.

Besondere Vorteile ergeben sich dann, wenn das elektrische Modul eine Leiterplatte mit darauf montierten Kontaktelementen ist oder eine plattenförmige Gestalt besitzt. Gemäß einer vorteilhaften Weiterbildung der Erfindung ist dann vorgesehen, daß die Leiterplatte freiliegend, d.h. von außen im Durchtrittsbereich des Kunststoffgegehäuses sichtbar in diesem aufnehmbar ist. Erfindungsgemäß ist dann mindestens ein Dichtelement die Durchtrittsöffnung umschließend an das Kunststoffgehäuse angespritzt. Vorteilhafterweise kann hierbei bei der Herstellung des Kunststoffgehäuses das Dichtelement nach dem Spritzen des Gehäusekörpers auf der gleichen Spritzmaschine mit einem elastomeren Kunststoff angespritzt und somit fest verbunden werden. Eine derartige Vorgehensweise besitzt den Vorteil, daß hierbei eine unkritische Montage auch einer vorbestückten Leiterplatte mit einem dennoch werkzeugfallenden Gehäuse möglich ist.

Eine weitere vorteilhafte Weiterbildung der Erfindung sieht vor, daß auf die in der Durchtrittsöffnung freiliegende Leiterplatte mindestens ein Dichtelement aufgedruckt oder mit einem Dispenser aufgetragen wird, welches die Durchtrittsöffnung abdichtend umschließt. Diese vorzugsweise noch im Nutzen durchzuführende Vorgangsweise besitzt wiederum den Vorteil, daß auch hier eine unkritische Montage auch einer vorbestückten Leiterplatte möglich ist, wobei aber in vorteilhafter Art und Weise gewährleistet ist, daß auch bei dieser kostengünstigen Herstellungsart des Kunststoffgehäuses eine hinreichende Dichtheit des Übergangsbereichs zwischen der Durchtrittsöffnung des Kunststoffgehäuses und dem elektrischen Modul, insbesondere der Leiterplatte, gewährleistet ist.

Eine weitere vorteilhafte Weiterbildung der Erfindung sieht vor, daß die Durchtrittsöffnung des erfindungsgemäßen Gehäuses durch ein Dichtelement aus elastischem Material, insbesondere aus elastomerem Kunststoff, abgedeckt wird, das nach dem Spritzen des Grundkörpers angespritzt und somit fest verbunden wird. Bei diesem aus elastischem Material bestehenden Boden der Durchtrittsöffnung ist für jedes einzelne Kontaktelement ein Durchbruch vorgesehen, durch den das auf der Leiterplatte montierte Kontaktelement durchtreten kann.

In vorteilhafter Art und Weise bildet der als Dichtelement fungierende Boden der Durchtrittsöffnung des Kunststoffgehäuses für jedes Kontaktelement eine zusätzliche Dichtung aus und bewirkt darüberhinaus, daß das elektronische Modul gegenüber dem Gehäuseäußeren abgedichtet ist, wodurch in einfacher Art und Weise ein Schutz vor Beschädigungen erreicht wird und Montagetoleranzen der Kontaktelemente gegenüber den Gehäusedurchbrüchen aufgefangen werden können.

Weitere vorteilhafte Weiterbildungen der Erfindung ergeben sich aus den Unteransprüchen.

Weitere Einzelheiten der Erfindung sind den Ausführungsbeispielen zu entnehmen, welche anhand der Figuren beschrieben werden.

Es zeigen:
- Figur 1: ein erstes Ausführungsbeispiel eines Kunststoffgehäuses,
- Figur 2: ein zweites Ausführungsbeispiel des Kunststoffgehäuses und
- Figur 3: ein drittes Ausführungsbeispiel des Kunststoffgehäuses.

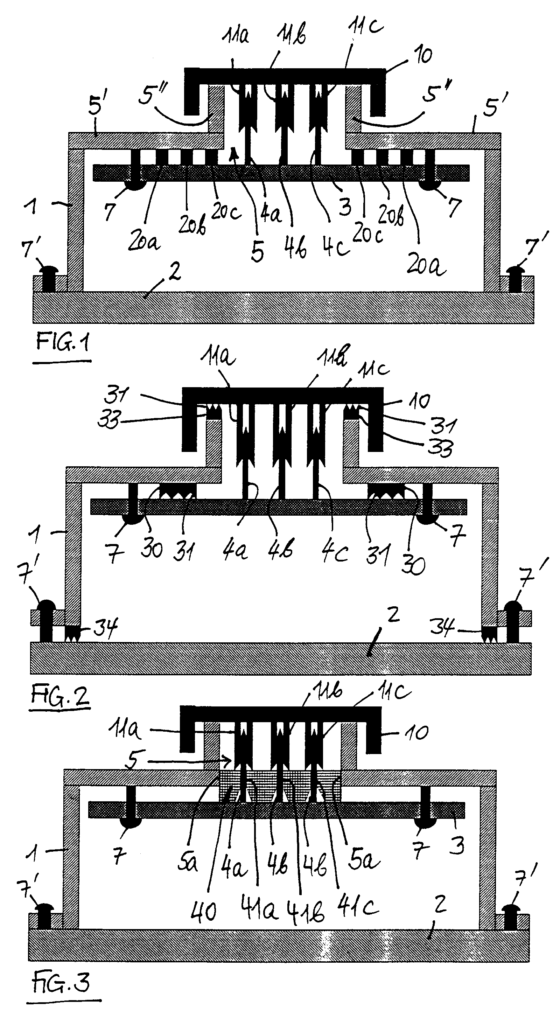

Das in Figur 1 dargestellte erste Ausführungsbeispiel weist einen an und für sich bekannten und daher nicht näher beschriebenen Gehäusekörper 1 aus einem auf den jeweiligen Einsatzort und Einsatzwzeck des Kunststoffgehäuses abgestimmten Kunststoffmaterial auf. In den durch eine Bodenplatte 2 dicht verschließbaren Gehäusekörper 1 ist ein elektrisches Modul, in dem hier beschriebenen Fall eine Leiterplatte 3, aufnehmbar, die auf geeignete Art und Weise, wie z.B. Ultraschallverschweißung 7 - mit dem Gehäusekörper 1 verbindbar ist.

Die Leiterplatte 3 weist mehrere elektrisch leitende, metallische Kontaktelemente 4a, 4b und 4c auf, die durch eine Durchtrittsöffnung 5 des Gehäusekörpers 1 hindurchtreten, um mit entsprechenden Kontaktelementen 11a-11c eines gehäuseexternen Gegensteckers 10 in Kontakt zu treten. Hierbei ist anzumerken, daß die gezeigte, die als Steckerfeld fungierende Durchtrittsöffnung des Kunststoffgehäuses überdeckende und abdichtende Ausführung des Gegensteckers 10 zwar vorteilhaft, aber nicht zwingend erforderlich ist. Desweiteren soll erwähnt werden, daß der Begriff "Kontaktelemente" in seiner umfassendsten Bedeutung zu verstehen ist, sodaß hierunter nicht nur die o.g. metallischen Kontaktelemente 4a-4c, sondern vielmehr jedwede eine bauliche oder funktionale Verbindung zwischen dem elektrischen Modul 3 im Gehäuseinneren und einer externen Einheit herstellende Elemente umfassen soll.

Wichtig ist nun die Anordnung und Ausbildung von Dichtelementen 20a, 20b und 20c, die das durch den Gehäusekörper 1, die Bodenplatte 2 und - im Bereich der Durchtrittsöffnung - durch die Leiterplatte 3 begrenzten Gehäuseinnere des Kunststoffgehäuses gegenüber der Gehäuseumgebung abdichten. Diese drei Dichtelemente 20a-20c, welche die Durchtrittsöffnung des Gehäusekörpers 1 entlang ihres Umfangsbereichs 5' dichtend umschließen, sind in besonders vorteilhafter Art und Weise auf die Leiterplatte 3 aufgebracht, indem ein elastisches Material, insbesondere ein elastomerer Kunststoff, auf die Leiterplatte 3 gedruckt oder dispensiert und dann ggfs. mittels Wärme- oder UV-Strahlung ausgehärtet wird. Eine derartige Vorgehensweise besitzt den Vorteil, daß das Aufbringen der Dichtelemente 20a-20c auf die Leiterplatte 3 besonders einfach und daher kostengünstig möglich ist.

Nachdem auf diese Art und Weise eine das Gehäuseinnere des Kunststoffgehäuses vorzugsweise staub- und wasserdicht abschirmende Dichtung ausgebildet wurde, wird die Leiterplatte 3 anschließend unter einem definierten Anpreßdruck im Gehäusekörper 1 mittels der Ultraschallverschweißung 7 montiert. Nach dem Aufsetzen und Arretieren der Bodenplatte 2 auf den Gehäusekörper 1 - welches vorzugsweise ebenfalls mittels einer weiteren Ultraschallverschweißung 7' durchgeführt wird - ist eine hermetische Abdichtung des im Gehäuseinneren des Kunststoffgehäuses aufgenommenen elektrischen Moduls (hier: der Leiterplatte) gewährleistet. Von Vorteil ist hierbei außerdem, daß eine unkritische Montage auch einer vorbestückten Leiterplatte 3 mit einem dennoch werkzeugfallenden Gehäuse möglich ist.

Abschließend zum ersten Ausführungsbeispiel der Fig. 1 ist noch anzumerken, daß es nicht unbedingt erforderlich ist, drei Dichtelemente 20a-20c vorzusehen. Vielmehr ist eine beliebige Zahl von Dichtelementen denkbar.

Bei dem in Figur 2 dargestellten Ausführungsbeispiel sind Bauteile des Kunststoffgehäuses, die mit Bauteilen des in Figur 1 dargestellten ersten Ausführungsbeispiels identisch oder zumindest weitgehend ähnlich sind, mit gleichen Bezugszeichen versehen und werden zur Vermeidung von Wiederholungen nicht mehr näher beschrieben.

Der grundlegende Unterschied zwischen diesen Ausführungsbeispielen besteht darin, daß ein den Dichtelementen 20a-20c des ersten Ausführungsbeispiels entsprechendes Dichtelement 30 aus elastischem Material, insbesondere aus elastomerem Kunststoff, nun nicht mehr auf der Leiterplatte 3 aufdispensiert oder aufgedruckt ist, sondern daß vorgesehen ist, daß das Dichtelement 30 an den Gehäusekörper 1 des Kunsstoffgehäuses angespritzt und damit fest mit diesem verbunden ist. Diese in einer besonders kostengünstigen Herstellungsart resultierende Vorgehensweise besitzt den Vorteil, daß der Gehäusekörper 1 samt dem aus einem elastischen Material bestehenden Dichtelement 30 in zwei unmittelbar aufeinanderfolgenden Arbeitsschritten eines einzigen Arbeitsganges mit einer herkömmlichen Zweifarben-Spritzmaschine durchgeführt werden kann. Außerdem ist hierbei von Vorteil, daß auch hier eine unkritische Montage auch einer vorbestückten Leiterplatte mit einem dennoch werkzeugfallenden Gehäuekörper 1 möglich ist.

Es bedarf keiner weiteren Erwähnung, daß es auch möglich ist, anstelle des in Figur 2 gezeigten einzigen Dichtelements 30 mit Dichtprofil 31 auch zwei oder mehrere Dichtelemente 30 um den äußeren Umfangsbereich 5' der Durchtrittsöffnung 5 umlaufend anzuordnen. Deweiteren ist es auch möglich, eine Kombination aus dem auf die Leiterplatte 3 aufdispensierten Dichtelementen 20a-20c des ersten Ausführungsbeispiels und dem an den Gehäusekörper 1 angespritzten Dichtelement 30 vorzusehen.

Wie es aus der Figur 2 weiterhin ersichtlich ist, läßt sich der eben beschriebene Grundgedanke - nämlich eine Dichtung durch Anspritzen eines aus elastischem Material, insbesondere aus elastomerem Kunststoff, bestehenden Dichtelemente an einen aus einem entsprechenden Kunststoff bestehenden Gehäusekörper 1 auszubilden - nicht nur zur Abdichtung der Durchtrittsöffnung 5 des Gehäusekörpers 1 verwenden. Vielmehr ist es auch möglich, auf diese Art und Weise eine Dichtung aus elastischem Material, insbesondere aus elastomerem Kunststoff, zwischen dem Gegenstecker 10 und einem nach außen vorspringenden Begrenzungsrand 5'' der Durchtrittsöffnung 5 auszubilden, indem beispielsweise an den Endflächen dieses Begrenzungsrands 5'' mindestens ein vorzugsweise mit einem Dichtprofil 31 versehenes weiteres Dichtelement 33 aus elastischem Material, insbesondere aus elastomerem Kunststoff wie beschrieben angespritzt wird.

Dieselbe Vorgangsweise ist auch zur Abdichtung der Bodenplatte 2 und des Gehäusekörpers 1 anwendbar, indem an den Gehäusekörper 1 in entsprechender Art und Weise ein zusätzliches Dichtelement 34 angespritzt wird.

Das in Figur 3 dargestellte dritte Ausführungsbeispiel des Kunststoffgehäuses, bei dem wiederum gleiche Teile mit gleichen Bezugsziffern versehen sind, unterscheidet sich von dem in Fig. 2 dargestellten zweiten Ausführungsbeispiel dadurch, daß die die Verbindung zwischen Leiterplatte 3 und Gehäusekörper 1 vorzugsweise staub- und wasserdicht abschließende Dichtung nicht im äußeren Umfangsbereich 5' der Durchtrittsöffnung 5 angeordnet ist.

Vielmehr ist vorgesehen, daß ein Dichtelement 40 die Leiterplatte 3 im Durchtrittsbereich des Gehäusekörpers 1 vorzugsweise ganz oder zumindest teilweise abdeckt, indem in diesem Bereich das einen Boden der Durchtrittsöffnung 5 ausbildende Dichtelement 40 an den inneren Umfangsrand 5a der Durchtrittsöffnung 5 des Gehäusekörpers 1 angespritzt wird.

Hierbei ist wieder von Vorteil, daß die Ausbildung des Gehäusekörpers 1 aus einem entsprechenden Kunststoff samt dem aus einem elastischen Material, insbesondere einem elastomeren Kunststoff bestehenden, fest mit dem Gehäusekörper 1 verbundenenen Dichtelement 40 in zwei unmittelbar aufeinanderfolgenden Arbeitsschritten eines einzigen Arbeitsgangs mittels einer bekannten Zweifarben-Spritzmaschine durchgeführt werden kann, was in vorteilhafter Art und Weise in einer kostengünstigen Herstellung resultiert. Von Vorteil hierbei ist außerdem, daß der beschriebene Aufbau hinsichtlich Toleranzen und Schrumpfungen unproblematisch ist, und daß die Leiterplatte 3 nicht mehr - wie bei den ersten beiden Ausführungsbeispielen der Fig. 1 und 2 - in der Durchtrittsöffnung 5 des Gehäusekörpers 1 freiliegend ist, sondern daß vielmehr das Dichtelement 40 die Leiterplatte 3 zumindest teilweise abdeckt und so vor Beschädigungen schützt.

Im Dichtelement 40 ist für jedes Kontaktelement 4a-4c je ein Duchbruch 41a-41c vorgesehen, sodaß beim Einsetzen der Leiterplatte 3 in den Gehäusekörper 1 die einzelnen Kontaktelemente 4a-4c durch die entsprechenden Durchbrüche 41a-41c hindurchtreten.

Selbstverständlich kann vorgesehen sein, daß zusätzlich zu dem Dichtelement 40 noch eine weitere Dichtung in Form einer Kombination der Dichtelemente 20a-20c und/oder des Dichtelements 30 im Umfangsbereich 5' der Durchtrittsöffnung 5 vorgesehen ist. Außerdem können der Gegenstecker 10 und die Bodenplatte 2 wie anhand der Figur 2 beschrieben abgedichtet werden.

Es soll noch erwähnt werden, daß als elastisches Material auch ein Acrylatklebstoff, insbesondere ein einkomponentiger, lichthärtender Klebstoff auf Polyethermethacrylatbasis eingesetzt werden kann.

Zusammenfassend ist festzustellen, daß all diese Dichtungen in einem einzigen Arbeitsgang hergestellt werden können und eine zuverlässige, feste und dichte Verbindung mit dem Gehäusekörper 1 oder dem elektrischen Modul 3 darstellen, wobei der Gehäusekörper dennoch ein werkzeugfallendes Kunststoffeil bleibt.

## Patentansprüche

1. Kunststoffgehäuse für ein elektrisches Modul, das einen Gehäusekörper (1) mit mindestens einer Durchtritttsöffnung (5) für Kontaktelemente (4a-4c) des im Gehäusekörper (1) aufnehmbaren elektrischen Moduls (3) aufweist, wobei der Gehäusekörper (1) und/oder das elektrische Modul (3) mindestens ein die Durchtrittsöffnung (5) abdichtendes Dichtelement (20a-20c;30;40) aus elastischem Material aufweist, und wobei das mindestens eine Dichtelement (20a-20c;30;40) aus elastischem Material auf den Gehäusekörper (1) und/oder auf dem elektrischen Modul (3) aufgespritzt oder aufgedruckt oder aufdispensiert ist.

2. Kunststoffgehäuse nach Anspruch 1, **dadurch gekennzeichnet,** daß das mindestens eine Dichtelement (20a-20c;30;40) aus elastischem Material auf dem Gehäusekörper (1) und/oder auf dem elektrischen Modul (3) im äußeren Umfangsbereich (5') der Durchtrittsöffnung (5) für die Kontaktelemente (4a-4c) angeordnet sind.

3. Kunststoffgehäuse nach Anspruch 1, **dadurch gekennzeichnet,** daß der Gehäusekörper (1) und/oder das elektrische Modul (3) mehrere Dichtelemente (20a-20c;30;40) aufweisen.

4. Kunststoffgehäuse nach Anspruch 1, **dadurch gekennzeichnet,** daß das Dichtelement (40) an den inneren Umfangsrand (5a) der Durchtrittsöffnung (5) des Gehäusekörpers (1) angespritzt ist und diese zumindest teilweise überdeckt.

5. Kunststoffgehäuse nach Anspruch 4, **dadurch gekennzeichnet,** daß das Dichtelement (40) sich über den gesamten Innenbereich der Durchtrittsöffnung (5) des Gehäusekörpers (1) erstreckt.

6. Kunststoffgehäuse nach einem der Ansprüche 4 oder 5, **dadurch gekennzeichnet,** daß das Dichtelement (40) Ausnehmungen (41a-41c) für die Kontaktelemente (4a-4c) aufweist.

7. Kunststoffgehäuse nach einem der Ansprüche 1 bis 6, **dadurch gekennzeichnet,** daß der Gehäusekörper (1) an einem die Durchtrittsöffnung (5) begrenzenden Rand (5'') ein den Gehäusekörper (1) gegenüber einen in die Durchtrittsöffnung (5) einsetzbaren Gegenstecker (10) abdichtendes weiteres Dichtelement aus elastischem Material (33) aufweist.

8. Kunststoffgehäuse nach einem der Ansprüche 1 bis 7, **dadurch gekennzeichnet,** daß der Gehäusekörper (1) und/oder eine Bodenplatte (2) des Kunststoffgehäuses ein aufgedrucktes oder mit einem Dispenser aufgetragenes oder angespritztes zusätzliches Dichtelement (34) aus elastischem Material aufweist.

9. Kunststoffgehäuse nach einem der Ansprüche 1 bis 8, **dadurch gekennzeichnet,** daß das elastische Material ein elastomerer Kunststoff oder ein Acrylatklebstoff, insbesondere ein einkomponentiger, lichthärtender Klebstoff auf Polyethermethacrylatbasis, ist.

10. Verfahren zur Herstellung eines Dichtelements für ein Kunststoffgehäuse, **dadurch gekennzeichnet,** daß das aus elastomeren Kunststoff bestehende Dichtelement (20a,20b,20c, 30,33,34,40) auf einen Gehäusekörper (1) und/oder auf eine Bodenplatte (2) des Kunststoffgehäuses gedruckt oder mit einem Dispenser aufgetragen oder angespritzt wird.

11. Verfahren nach Anspruch Anspruch 10, **dadurch gekennzeichnet,** daß das Anspritzen des Dichtelements (30,33,34,40) mit einer Zweifarben-Spritzmaschine durchgeführt wird.
